(19)

Europäisches
Patentamt
European
Patent Office
Office européen
des brevets

(11) **EP 1 855 384 B1**

(12) **EUROPEAN PATENT SPECIFICATION**

(45) Date of publication and mention
of the grant of the patent:
**25.08.2010 Bulletin 2010/34**

(51) Int Cl.:
***H03M 3/02*** *(2006.01)*

(21) Application number: **07075367.8**

(22) Date of filing: **26.09.2003**

(54) **Accumulator for adaptive sigma-delta modulation**

Akkumulator für adaptive Sigma-Delta-Modulation

Accumulateur pour modulation sigma-delta adaptative

(84) Designated Contracting States:
**AT BE BG CH CY CZ DE DK EE ES FI FR GB GR
HU IE IT LI LU MC NL PT RO SE SI SK TR**

(43) Date of publication of application:
**14.11.2007 Bulletin 2007/46**

(62) Document number(s) of the earlier application(s) in
accordance with Art. 76 EPC:
**03758484.4 / 1 665 544**

(73) Proprietor: **Med-El Elektromedizinische Geräte
GmbH
6020 Innsbruck (AT)**

(72) Inventor: **Zierhofer, Clemens M.
6250 Kundl (AT)**

(74) Representative: **Froud, Clive
Clive Froud & Co Limited
7 Hurst Close
Tenterden
Ashford
Kent TN30 6UG (GB)**

(56) References cited:
WO-A-02/09292          US-A- 4 860 012
US-A1- 2003 146 865    US-B1- 6 535 153

- ZIERHOFER C M: "ADAPTIVE SIGMA-DELTA
  MODULATION WITH ONE-BIT QUANTIZATION"
  IEEE TRANSACTIONS ON CIRCUITS AND
  SYSTEMS II: ANALOG AND DIGITAL SIGNAL
  PROCESSING, IEEE INC. NEW YORK, US, vol. 47,
  no. 5, 1 May 2000 (2000-05-01), pages 408-415,
  XP001009131 ISSN: 1057-7130
- ZIERHOFER C M ED - ZAJC B ET AL: "Numerical
  adaptive delta modulation-a technique for digital
  signal representation in ASIC applications"
  ELECTROTECHNICAL CONFERENCE, 1991.
  PROCEEDINGS., 6TH MEDITERRANEAN
  LJUBLJANA, SLOVENIA 22-24 MAY 1991, NEW
  YORK, NY, USA,IEEE, US, 22 May 1991
  (1991-05-22), pages 331-334, XP010039836 ISBN:
  0-87942-655-1

**Description**

**Technical Field**

The invention generally relates to signal processing, and more particularly, to analog to digital conversion using sigma-delta modulation.

**Background Art**

Sigma-delta ($\Sigma$-$\Delta$) modulation is a widely used and thoroughly investigated technique for converting an analog signal into a high-frequency digital sequence. See, for example, "Oversampling Delta-Sigma Data Converters," eds. J. C. Candy and G. C. Temes, IEEE Press, 1992, (hereinafter "Candy") and "Delta-Sigma Data Converters," eds. S. R. Northworthy, R. Schreier, G. C. Temes, IEEE Press, 1997.

In $\Sigma$-$\Delta$ modulation, a low-resolution quantizer is incorporated within a feedback loop configuration in which the sampling frequency is much higher than the Nyquist frequency of the input signal (i.e. much higher than twice the maximum input frequency). In addition, the noise energy introduced in the quantizer is shaped towards higher frequencies according to a so-called "noise-transfer-function" NTF(z), and the signal passes the modulator more or less unchanged according to a so-called "signal-transfer-function" STF(z).

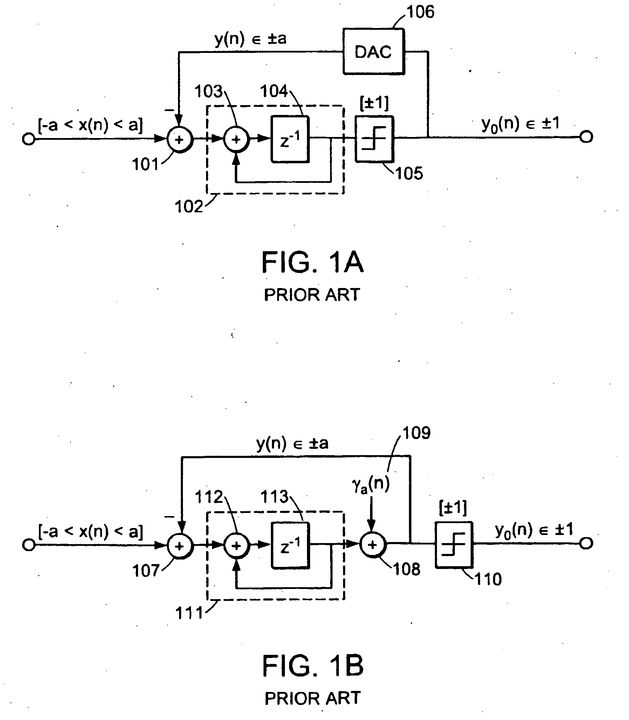

Fig. 1(a) depicts a simple first order $\Sigma$-$\Delta$ modulator for a discrete time system having a subtraction stage 101, an accumulator 102 (including an integrator adder 103 and a delay line 104), a one-bit quantizer 105, and a 1-bit digital-to-analog converter (DAC) 106. In normal operation, an input signal x(n) within the range [-a, +a] is converted to the binary output sequence $y_0(n) \in \pm 1$. Quantizer 105 produces a + 1 for a positive input and a - 1 for a negative input. The output from quantizer 105 is fed back through DAC 106 and subtracted from input signal x(n) by subtraction stage 101. Thus, the output of subtraction stage 101 represents the difference between input signal x(n) and the quantized output signal $y_0(n)$. As can be seen from Fig. 1(a), the output of accumulator 102 represents the sum of its previous input and its previous output. Thus, depending on whether the output of the accumulator 102 is positive or negative, the one-bit quantizer 105 outputs a + 1 or a - 1 as appropriate. Herein, and in the appended claims, analog (physical) and digital representations of signals are distinguished from each other by labeling digital one or multi-bit signals with the subscript "0".

In Fig. 1(b), a linear model of Fig. 1(a) is shown, and similarly includes a subtraction stage 107, and an accumulator 111 (including an integrator adder 112 and a delay line 113). Quantizer 105 is replaced by an adder 108 and a noise source 109. To convert signal y(n) to $y_0(n)$, a comparator 110 for detection of the sign of y(n) is included. The basic relationship between the z-transforms of system input x(n), quantizer noise $\gamma_a(n)$, and the two-level output sequence y(n) is:

$$Y(z) = z^{-1} X(z) + (1 - z^{-1}) \Gamma_a(z) \qquad\qquad\qquad (1)$$

The signal-transfer-function and noise-transfer-function can be identified as STF(z) = $z^{-1}$ and NTF(z) = $(1 - z^{-1})$, respectively.

Quality of digital representation can be described by the signal-to-noise ratio SNR = $10 \log_{10} S/N$, where S is the signal power and N is the noise power within a given bandwidth B. Regarding equation (1), the noise power N depends on both the noise-transfer-function NTF (z) and the overall amount of noise $\Gamma a(z)$ added in the quantization stage. To improve the SNR, two approaches can be pursued:

(a) for a given overall noise power $\Gamma_a(z)$, i.e. for given quantizer levels $\pm a$, modify the NTF(z) to remove more noise power from the base band by improved noise shaping, and
(b) for a given NTF(z), try to reduce the overall noise power introduced to the system.

Approach (a) can be achieved, for example, by increasing the order of the sigma-delta modulator, as described by Candy. For higher order modulators, the noise-transfer-function becomes NTF(z) = $(1 - z^{-1})^k$, which means an enhanced noise-shaping effect. For examples of approach (b) see Zierhofer C. M., "Adaptive sigma-delta modulation with one-bit quantization," IEEE trans. CAS II, vol. 47, No. 5, May 2000 (hereinafter "Zierhofer"), U.S. Patent Application for "Adaptive Sigma-delta Modulation with One-bit Quantization", Serial No.: 09/496,756, filed February 3, 2000, which issued as U.S. Patent 6,535,153, and U.S. Patent Application for "Adaptive Sigma-delta Modulation with One-bit Quantization", Serial No. 10/357,613, which published as 2003/0146865, where a sigma-delta modulator is employed within a feedback loop configuration. It is shown that the input signal of this modulator applies within a reduced range, and thus the two levels of the quantizer can be reduced. As a consequence, less noise power is introduced to the system, and the SNR is improve.

## Summary of the Invention

The present invention provides an adaptive sigma delta modulator according to claim 1.

The present invention also provides a method of adapting sigma delta modulation according to claim 10.

Having indicated the scope of the present invention, it will now be further described and illustrated in context in more general terms.

In connection with developing an adaptive sigma-delta ($\Sigma$-$\Delta$) modulator, a new accumulator stage for use in a non-adaptive or adaptive sigma-delta ($\Sigma$-$\Delta$) modulator was invented. In accordance with one embodiment of the invention, a system and method for an adaptive sigma-delta ($\Sigma$-$\Delta$) includes an input stage that produces a difference signal representing the difference between an analog input signal $x(n)$ and an analog feedback signal $z(n)$. The amplitude of the analog input signal $x(n)$ is within a first range $[-a, +a]$. An accumulator stage produces an accumulated signal that is a function of an accumulation of the difference signal, the accumulator stage transforming the accumulation of the difference signal so as to increase average magnitude while ensuring instantaneous magnitude does not exceed a predetermined value. A quantization stage produces a quantized digital signal $y_0(n)$ representing the accumulated signal. Based on the quantized digital signal $y_0(n)$, an adaptation stage produces a digital output signal $z_0(n)$, which is converted to the analog feedback signal $z(n)$ by a digital-to-analog converter.

In related embodiments of the invention, the adaptation stage tends to keep the instantaneous magnitude of the analog feedback signal $z(n)$ within the first range $[-a, +a]$ and greater than the analog input signal's $x(n)$ instantaneous magnitude. The accumulator stage may include an accumulation capacitor, the charge across the capacitor representing an accumulation of the difference signal. The accumulated signal may be based, at least in part, on the voltage across the accumulation capacitor. The capacitance across the accumulation capacitor may be variably controlled such that average magnitude of voltage across the accumulation capacitor is increased while ensuring instantaneous magnitude of voltage across the accumulation capacitor does not exceed the predetermined value. The accumulation capacitor may be coupled between an input and an output of an operational amplifier.

In further related embodiments of the invention, the adaptation stage may include a multiplier stage that multiplies the quantized digital signal $y_0(n)$ by a step size $c_0(n)$, and the capacitance across the accumulation capacitor is variably controlled base, at least in part, on the step size $c_0(n)$. The accumulation capacitor may include an array of capacitors, each capacitor in the array capable of being switched so as to vary the capacitance across the accumulation capacitor.

In still further related embodiments of the invention, the digital-to-analog converter may include an array of weighted capacitors, the array of weighted capacitors capable of acquiring a charge $Q_{DAC}(n)$ negatively proportional to the digital output signal $z_0(n)$. The input sampling stage may include an input sampling capacitor, the input sampling capacitor capable of acquiring a charge $Q_{in}(n)$ proportional to the analog input signal $x(n)$.

In yet other related embodiments of the invention, the quantized digital signal $y_0(n)$ produced may include a two-level digital output sequence. The two-level digital output may include values of +1 and -1. Producing the digital output signal $z_0(n)$ may include multiplying the quantized digital signal $y_0(n)$ by a step size $c_0(n)$. The step size $c_0(n)$ may be based on a set Y of code words, where $Y=\{y_0(n), y_0(n-1), y_0(n-2)...y_0(n-n_x)\}$, $n_x$ being a predetermined integer. Determining the step size $c_0(n)$ may include increasing the step size $c_0(n)$ if a majority of the code words are equal, or decreasing the step size $c_0(n)$ if the code words alternate. The step size $c_0(n)$ may be non-linear. Multiplying the quantized digital signal $y_0(n)$ by a step size $c_0(n)$ may include using a look-up-table RAM.

In another embodiment of the invention, a system and method for an adaptive sigma delta modulator includes an input stage that produces a difference signal representing the difference between an analog input signal $x(n)$ and an analog feedback signal $z(n)$. The amplitude of the analog input signal $x(n)$ is within a first range $[-a, +a]$. An accumulator stage produces an accumulated signal that is a function of an accumulation of the difference signal. The accumulator stage includes an accumulation capacitor having a capacitance that is capable of being variable controlled. The charge of the accumulation capacitor represents the accumulation of the difference signal. A quantization stage produces a quantized digital signal $y_0(n)$ representing the accumulated signal. Based on the quantized digital signal $y_0(n)$ an adaptation stage produces a digital output signal $z_0(n)$. A digital-to-analog converter stage converts the digital output signal $z_0(n)$ to the analog feedback signal $z(n)$.

In related embodiments of the invention, the accumulation capacitor may be variably controlled so as to increase the average magnitude of the voltage across the accumulation capacitor while ensuring an instantaneous magnitude of the voltage across the accumulation capacitor does not exceed a predetermined value. The accumulation capacitor may include an array of capacitors, each capacitor in the array capable of being switched so as to vary the capacitance across the accumulation capacitor. The adaptation stage may include a multiplier stage that multiplies the quantized digital signal $y_0(n)$ by a step size $c_0(n)$, and wherein the capacitance across the accumulation capacitor is variably controlled based, at least in part, on the step size $c_0(n)$. The adaptation stage may tend to keep the instantaneous magnitude of the analog feedback signal z(n) within the first range [-a, +a] and greater than the analog input signal's x(n) instantaneous magnitude.

In accordance with another embodiment of the invention, a sigma delta modulator includes an input stage that produces a difference signal representing the difference between an analog input signal x(n) and an analog feedback signal z(n). An accumulator stage produces an accumulated signal that is a function of an accumulation of the difference signal. In particular, the accumulator stage transforms the accumulation of the difference signal so as to increase average magnitude while ensuring instantaneous magnitude does not exceed a predetermined value. A quantization stage produces a quantized digital signal $y_0(n)$ representing the accumulated signal. A digital-to-analog converter stage converts the digital signal $y_0(n)$ to the analog feedback signal z(n).

## Brief Description of the Drawings

The present invention will be more readily understood by reference to the following detailed description taken with the accompanying drawings, in which:

Fig. 1(a) is a block diagram of a prior art first order $\Sigma$-$\Delta$ modulator for a discrete time system;
Fig. 1(b) is a block diagram of a prior art first order $\Sigma$-$\Delta$ modulator for a linear model, where the quantizer is replaced by an adder and a noise source;
Fig. 2 is a block diagram of an adaptive sigma-delta ($\Sigma$-$\Delta$) modulator with one bit quantization that improves the signal-to-noise (SNR) of a $\Sigma$-$\Delta$ modulator in accordance with one embodiment of the invention;
Fig. 3(a) shows representative waveforms for an adaptive sigma-delta ($\Sigma$-$\Delta$) modulator in accordance with one embodiment of the invention;
Fig. 3(b) shows representative waveforms for an adaptive sigma-delta ($\Sigma$-$\Delta$) modulator in accordance with one embodiment of the invention;
Fig. 4 shows SNR-simulation results representative of various types of analog-to-digital converters;
Fig. 5 shows SNR-simulation results representative for adaptive sigma-delta ($\Sigma$-$\Delta$) modulators with ideal and non-ideal digital-to-analog converters in accordance with one embodiment of the invention;
Fig. 6 is a block diagram of an adaptive sigma-delta ($\Sigma$-$\Delta$) modulator with one bit quantization that includes a high pass filter stage in accordance with one embodiment of the invention;
Fig. 7 is a block diagram of an adaptive sigma-delta ($\Sigma$-$\Delta$) modulator with one bit quantization having a high pass filter stage that includes a numeric multibit sigma-delta modulator in accordance with one embodiment of the invention;
Fig. 8 shows representative waveforms for the system depicted in Fig. 7;
Fig. 9 shows SNR-simulation results pertaining to the signal-to-noise ratio for the system depicted in Fig. 7;
Fig. 10 shows a block diagram of an analog stage of an adaptive sigma-delta modulator, in accordance with one embodiment of the invention; and
Fig. 11 shows a variable accumulation capacitor, in accordance with one embodiment of the invention.

## Detailed Description of Specific Embodiments

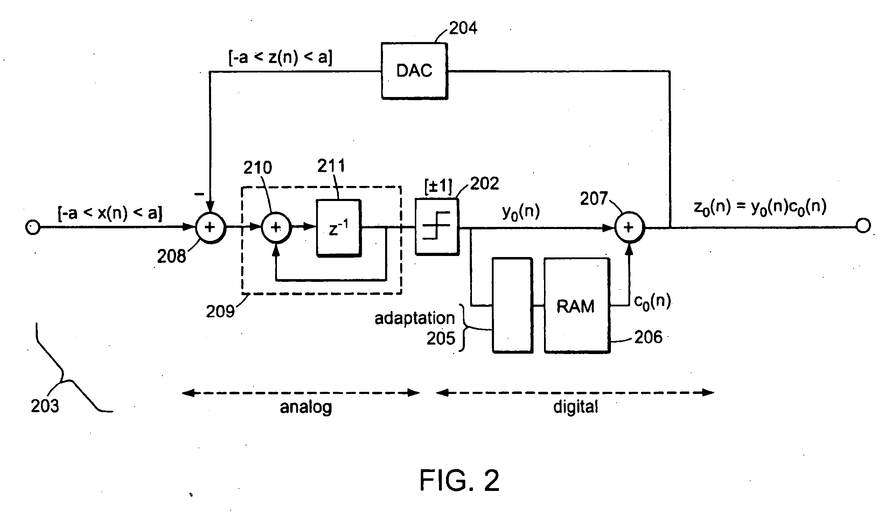

A method and system for an adaptive sigma-delta ($\Sigma$-$\Delta$) modulator with one bit quantization that improves the signal-to-noise (SNR) of a $\Sigma$-$\Delta$ modulator is presented. A block diagram of the system in accordance with one embodiment of the invention is shown in Fig. 2. The output $y_0(n)$ and two level feedback signal $y(n) \in \pm a$ of a standard $\Sigma$-$\Delta$ modulator of $1^{st}$ order is replaced by a multilevel output signal $z_0(n)$ and feedback signal z(n), respectively. The instantaneous magnitude of the multilevel feedback signal z(n) is kept within the range [-a < z(n) < a] and greater than the instantaneous magnitude of the input signal x(n) by an adaptation stage 205. Compared to the non-adaptive modulator, the noise source 107 in Fig. 1(b) is thus reduced, and the SNR is considerably enhanced. The adaptation algorithm of the adaptive $\Sigma$-$\Delta$ presented can be fully exploited, if the input x(n) is a zero-mean signal, or if the dc-component of x(n) is at least close to zero. If x(n) contains a considerable dc-component, the input dynamic range is reduced. Accordingly, an implementation of a high-pass filter stage is also presented.

Fig. 2 can be separated into an analog and a digital section. An analog input x(n) having range [-a, +a], is inputted into a subtraction stage 208. The analog output of the subtraction stage is then inputted into an accumulator 209 (including an integrator adder 210 and a delay line 211) and then quantized 202. The digital output of the quantizer 202, which may be, but is not limited to, $y_0(n) \in \pm 1$, is multiplied 207 by a step size sequence $c_0(n)$ to create output signal $z_0(n)$. Output signal $z_0(n)$ is passed through a digital-to-analog converter (DAC) 204 to create the analog feedback signal z(n).

Step size sequence $c_0(n)$ is generated in an adaptation stage 205. The step size $c_0(n)$ at a particular instant is controlled by a set of code words [$y_0(n)$, $y_0(n-1)$, $y_0(n-2)$, ... ], which represent the instantaneous value of $y_0(n)$, and

a particular (finite) number of previous code words $y_0(n-1)$, $y_0(n-2)$ ... The primary intention of adaptation stage 205 is to keep the instantaneous magnitude of $z(n)$ greater than the instantaneous magnitude of input signal $x(n)$,

$$|z(n)| > |x(n)|. \qquad\qquad (2)$$

The way the adaptation stage works is intuitively clear. Step size $c_0(n)$ needs to be increased, if the set $[y_0(n), y_0(n-1), y_0(n-2), ...]$ contains many equal code words. In this case, $|x(n)|$ tends to exceed $|z(n)|$, which violates condition (2). On the other hand, $c_0(n)$ needs to be decreased, if the set $[y_0(n), y_0(n-1), y_0(n-2),...]$ shows an alternating pattern of code words.

Using, for example, a 9-bit DAC 204 for the system shown in Fig. 2, the input range [-a, +a] is subdivided into 511 equally spaced discrete signal levels. Thus, the digital signals $z_0(n)$ and $c_0(n)$ are composed of 9 bits, and 8 bits, respectively. In accordance with one embodiment of the invention, an adaptation algorithm for a system of 1st order, with constant $\alpha$ chosen to be $\alpha = \dfrac{16}{15}$, is provided in Tab. 1.

As shown in Tab. 1, the step size is increased by approximately a factor $\alpha^3$, if five consecutive code words are equal, and decreased by about a factor $\alpha^{-1}$, if four consecutive code words have alternating signs. Since step sizes $c_0(n)$ have a limited resolution of 8-bits, the products $\alpha^3 c_0(n-1)$ and $\alpha^{-1}c_0(n-1)$ cannot be implemented exactly, but have to be rounded to the next integer. For small step sizes, the deviations due to rounding are considerable, but this type of imperfection is not essential

**Table 1**

| Code | Step Size Multiplier |
|---|---|
| $y_0(n) = y_0(n-1) = y_0(n-2) = y_0(n-3) = y_0(n-4)$ | $c_0(n) = \text{round}(\alpha^3 c_0(n-1))$ |
| $y_0(n) = -y_0(n-1) = y_0(n-2) = -y_0(n-3)$ | $c_0(n) = \text{round}(\alpha^{-1}c_0(n-1))$ |
| Other combinations | $c_0(n) = c_0(n-1)$ |

for the system performance. While a multiplier can be used to calculate $c_0(n)$, in various embodiments of the invention, a look-up-table RAM 206 is utilized instead, where all possible step sizes $c_0(n)$ are stored as 8-bit integers, for example. The minimum and maximum step sizes are then $c_{0,min}= 1$ and $c_{0,max}= 255$, respectively. The computation of product $\alpha^3 c_0(n)$ may be achieved by simply increasing the instantaneous RAM-address index by 3. Similarly, for product $\alpha^{-1}c_0(n)$, the instantaneous address index is decreased by 1.

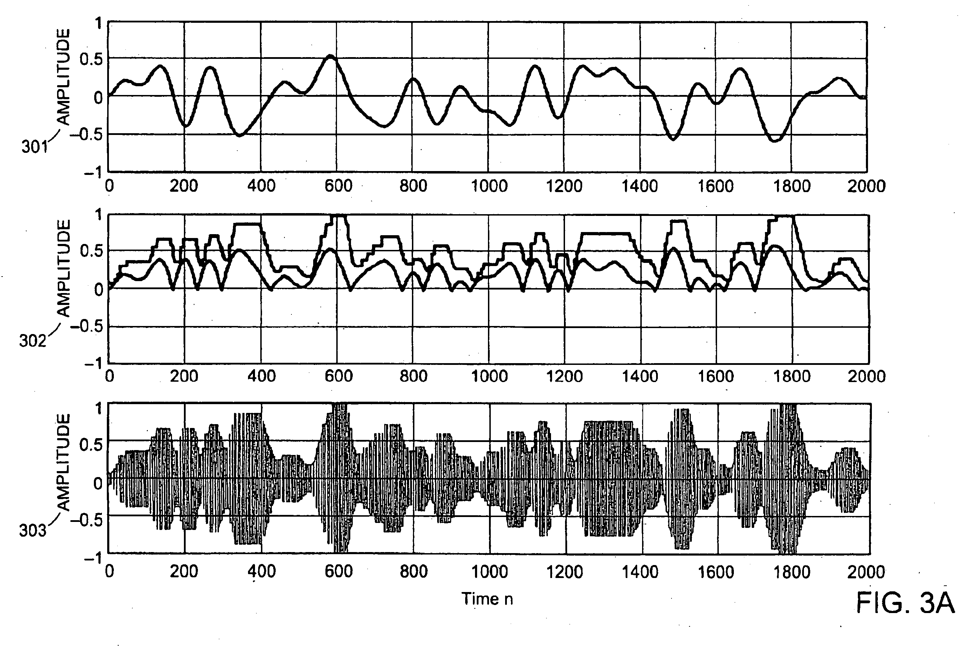

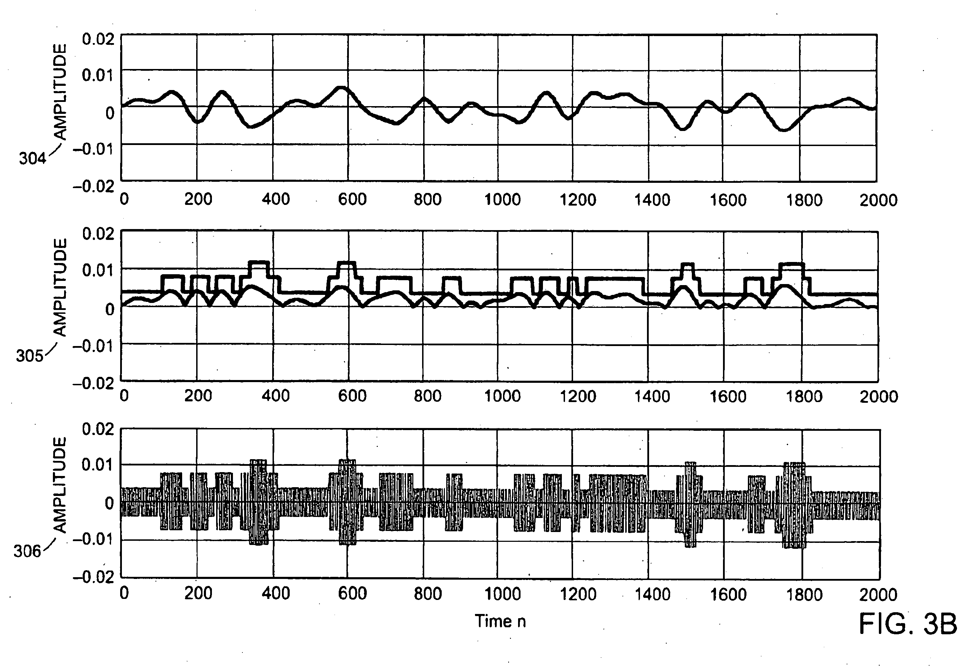

Sample waveforms for an adaptive $\Sigma$-$\Delta$ modulator implementing the adaptation algorithm described in Tab. 1 are shown in Figs. 3(a ) and 3(b). The first trace 301 in Fig. 3(a) depicts an example of an input signal $x(n)$. The second trace 302 in Fig. 3(a) shows the full wave rectified version $|x(n)|$ together with the magnitude $|z(n)|$ of the DAC-output signal. Condition (2) is fulfilled for almost all samples, but a close examination shows that there is a violation at instant n = 1643. This remains singular, however, and has negligible impact on the overall performance of the system. The third trace 303 in Fig. 3(a) illustrates the full DAC-output signal $z(n)$. In Fig. 3(b), the system behavior is shown, if signal $x(n)$ is attenuated by 40dB, i.e. for $x(n)/100$. Traces 304, 305, and 306 represent an input signal $x(n)$, the full wave rectified version $|x(n)|$ together with the magnitude $|z(n)|$ of the DAC-output signal, and the full DAC-output signal $z(n)$, respectively. As expected, the quantization of signals $|z(n)|$ and $z(n)$ appears more pronounced, and the digital sequence $c_0(n)$ varies between 1 and 3.

The examples Figs. 3(a) and 3(b) also demonstrate that the step-size adaptation algorithm works instantaneously, that is, step size multiplier $c(n)$ tracks the individual maxima and minima of input $x(n)$. Signal $c(n)$ can directly be used to estimate the instantaneous power of the input signal, which is advantageous, for example, in signal processing applications for automatic gain control (AGC) for speech signals. Adaptive $\Sigma$-$\Delta$ modulation schemes typically use comparatively slow adaptation algorithms, where time constants in the range of tens of milliseconds are involved (usually referred to as "syllabic compression"). An example is Chakravarthy, C. V., "An amplitude-controlled adaptive delta sigma modulator," Radio & Electronic Engineer (London), vol. 49, pp.49-54, January 1979. Systems like this cause gross errors in case of sudden increase of the amplitudes of the input signals and are not practical in signal processing applications, where a permanent accurate representation of the input signal is of importance. Additionally, the use of non-linear step sizes makes the adaptive algorithm more responsive to changes in input amplitudes compared to prior art adaptive algorithms with a constant step size, such as described in Jaggi, M. P., "Instantaneously Adaptive Delta Sigma Modulator", Can. Elect. Eng. 1, Vol 11 No. 1, 1986. This is important, for example, in keeping the instantaneous magnitude of the first analog feedback signal greater than the input signal's instantaneous magnitude.

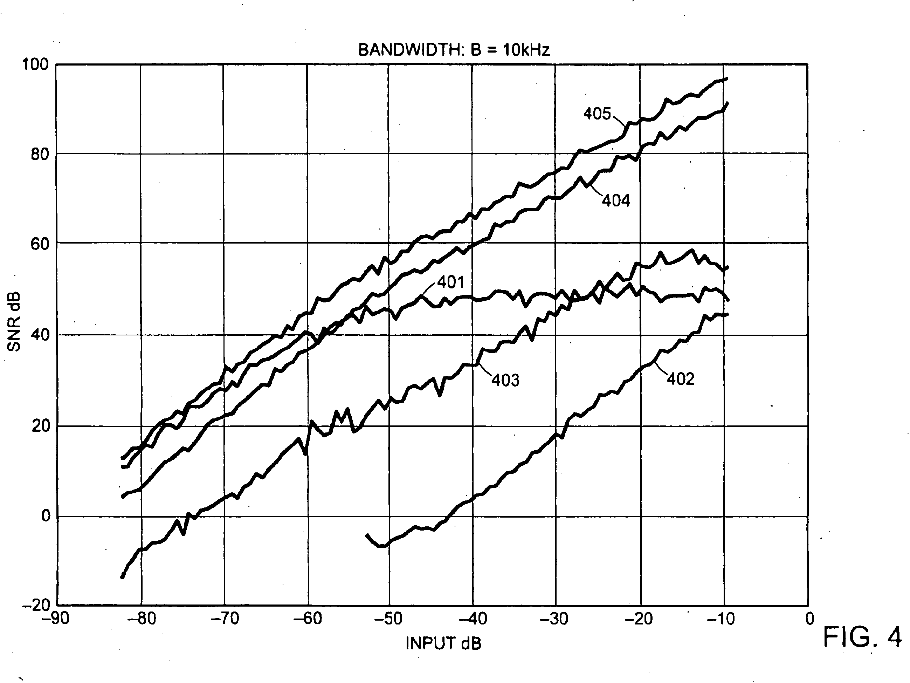

In Fig. 4, the SNR of various types of analog-to-digital converters are shown as a function of the input signal's power. The input $x(n)$, within the range $[-l < x(n) < 1]$ (i.e., $a = 1$), is a periodic zero-mean noise sequence composed of 10000 samples, and the bandwidth is $B = 10kHz$. Within this bandwidth, amplitudes and phases of the spectral lines are randomized. Different values of signal power are obtained by proportional amplification of this signal. The input power is referenced to the power level of a dc-signal with amplitude $a = 1$. At the maximum input power level shown in Fig. 4 (i.e., at -9.45dB), the maximum signal amplitude reaches 0.99, which is just below the limit of the reference level $a = 1$. The sampling rate for all systems is $1/_T = 1MHz$, and the SNRs are computed within $B = 10kHz$.

Curve 401 depicts the SNR of an ideal adaptive sigma-delta modulator in accordance with one embodiment of the invention, where the adaptation algorithm of Tab. 1 and a 9-bit DAC is used ($a = 1$). Reducing the input power from the maximum level to lower levels, the SNR tends to remain constant. For input levels smaller than about -50dB, the SNR is decreasing. Curve 402 is the SNR of an ideal standard sigma-delta modulator of 1st order with $y_a(n) \in \pm 1$. The maximum SNR is obtained at the maximum input power level, and a decrease of input power results in a decrease of the SNR. Comparing curves 401 and 402 clearly demonstrates the benefit of the adaptive-sigma delta modulator. Curve 402 is very similar to the segment of curve 401 having input levels smaller than about -50dB, shifted to the right by about 48dB. This shift reflects the additional 8 bits of signal $z(n)$ as compared to $y_a(n)$. For input levels smaller than about -50dB, the adaptive sigma-delta modulator operates in a manner similar to a standard sigma-delta modulator, since the feedback-signal $z(n)$ is a two-level signal, $z(n) \in \pm 1/256$. Note that for high input levels, the SNR of the adaptive modulator is not substantially higher than for the standard modulator. However, the input dynamic range has been expanded by approximately 48dB. Curve 403 depicts the SNR of a sigma-delta-modulator of 2nd order. Obviously, at lower input levels, the 2nd order system is outperformed by the adaptive modulator. Curves 404 and 405 depict the SNR's of Pulse Code Modulation (PCM) systems with 13 and 14 bit resolutions, respectively. Whereas the 14-bit PCM system is superior to the adaptive sigma-delta modulator for all input levels, the 13-bit PCM system is inferior at least at low-level input signals.

In accordance with one embodiment of the invention, the adaptive sigma-delta modulator includes a multi-bit DAC 204 in the feedback loop, as shown in Fig. 2, since the feedback signal $z(n)$ is a multi-level signal. In preferred embodiments of the invention, the specifications of this DAC 204 is chosen to have minimal effects on the SNR of the adaptive sigma-delta modulator. The non-ideal DAC can be regarded as an ideal converter plus a noise source, with the transfer function of this additional noise source being $-NTF(z) = -z^{-1}$. Thus, this noise (multiplied by -1) is directly added to the input signal and enhances the noise energy in the base band. For the DAC 204, the following assumptions can be made:

   (1) The distribution of DAC-errors is symmetric around zero.
   (2) Each discrete DAC-levels is implemented by means of superposition of binary weights.
   (3) Each binary weight itself is composed of elementary unit components. This implies, e.g., that for a particular binary weight which is composed of K unit components, the nominal value is increasing proportional to K, whereas the error is increasing proportional only to $\sqrt{K}$.

For example, for a 9-bit DAC, the pattern $c_0(n) = [10010101]$ contains the binary weights 128, 16, 4, and 1, and hence the nominal magnitude of the resulting DAC-level is $\dfrac{149}{255}\mathbf{a}$ However, the single weights can only be realized as

$$128\left(1 \pm \frac{\Delta}{\sqrt{128}}\right), \quad 16\left(1 \pm \frac{\Delta}{\sqrt{16}}\right), \quad 4\left(1 \pm \frac{\Delta}{\sqrt{4}}\right),$$ which results in a deviation from the nominal value.

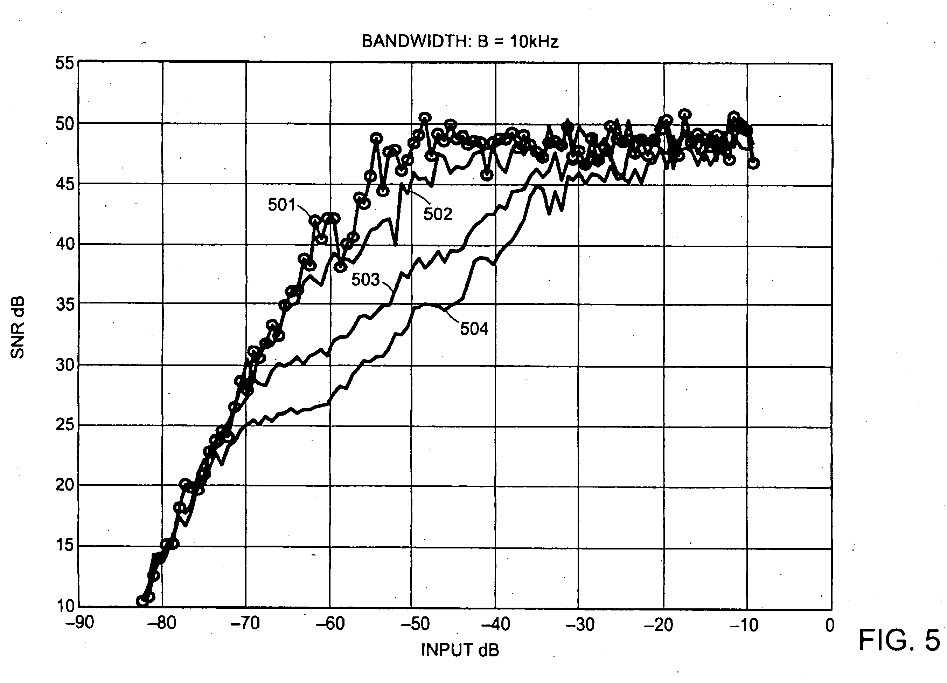

Fig. 5 shows the SNRs of an adaptive sigma-delta modulator with an ideal 9-bit DAC (A = 0) 501, and non-ideal DACs for A = 1% 502, A = 3% 503, and A = 5% 504, where $\Delta$ denotes the maximum deviation of the implemented level number K = 1 from the nominal value. In all cases, the contribution of the dc-offset error is omitted, and the input signal is the same as for Fig. 4 (N = 10000). Fig. 5 shows that the SNR reduction will be within acceptable limits with parameters $\Delta$ better than about $\Delta \approx 1\%$.

The adaptive sigma-delta modulator shown in Fig. 2 yields its optimum performance if the input $x(n)$ is a zero-mean signal, or if the dc-component of $x(n)$ is at least close to zero. However, if $x(n)$ contains a considerable dc-component, the input dynamic range is reduced. Consider, for example, an input signal with a dc-component and comparatively very small ac-component. The step size reduction will be governed by the de-component and not the ac-component, and thus it remains too large. Dc-components can be introduced from either the input signal directly, or by offset-errors due to non-ideal components of the modulator itself. In practical implementations, offset errors in the DAC might occur. In any case, a high-pass filter removes most problems involved with dc- or very low frequency components.

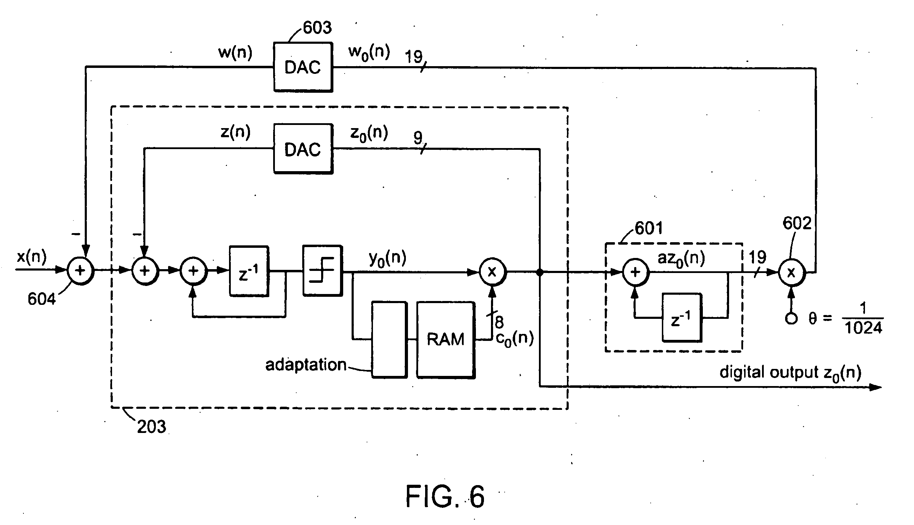

In accordance with one embodiment of the invention, an implementation of a high-pass filter is implemented as shown in Fig. 6. Here, the adaptive sigma-delta modulator 203 of Fig. 2 is embedded in a feedback loop system, which represents a typical digital high-pass filter. The digital output $z_0(n)$ of the modulator is first accumulated 601, resulting in signal $az_0(n)$, and then multiplied 602 by a factor $\theta$, resulting in signal $w_0(n)$. Digital-to-analog conversion of $w_0(n)$ by means of a second DAC 603 results in signal w(n), which is subtracted 604 from the input x(n). The overall signal-transfer-function $STF_{HP}(z)$ of such a system is given by

$$STF_{HP}(z) = STF(z)HP(z), \qquad\qquad (3)$$

with the standard $\Sigma$-$\Delta$ signal-transfer-function, i.e., $STF(z) = z^{-1}$, and the high-pass transfer-function

$$HP(z) = \frac{1 - z^{-1}}{1 - (1-\theta)z^{-1}} \cdot$$ There is a zero at z = 1 corresponding to a frequency f = 0, and a pole at z = 1-$\theta$. Using, for

example, a sigma-delta rate of 1MHz and $\theta = \dfrac{1}{1024}$ results in a 3-dB cut off frequency of about 150Hz.

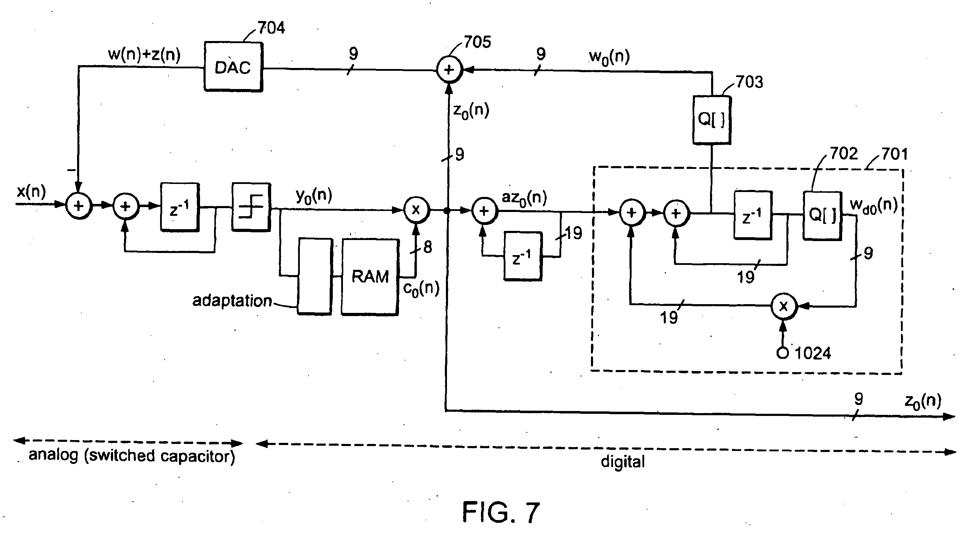

The system shown in Fig. 6 is not well suited for practical implementation, since a 19-bit DAC is involved. Therefore, in accordance with various embodiments of the invention, means to circumvent such a high precision DAC are implemented. In accordance with one embodiment of the invention, inserting a numeric version of a multibit sigma-delta modulator 701 into the system results, for example, in the system as shown in Fig. 7. Assuming $\theta = \dfrac{1}{1024}$, signal $az_0(n)$ comprises 19 bits. Following the general rules of sigma-delta modulation, this signal is converted to output signal $1024w_{d0}(n)$, which represents the input signal $az_0(n)$, delayed by one clock period. In the present application, signal $w_0(n) = w_{d0}(n+1)$ is used as a high-pass filter feedback signal, which represents the non-delayed input $az_0(n)$, multiplied by 1/1024. In the present embodiment, two identical 9-bit numeric quantizers 702 and 703 with a transfer characteristics of mid-tread-type are employed. Possible output numbers are -255, -254, .., -2, -1, 0, 1, 2, ... 254, 255. Note that using the numeric multibit sigma-delta modulator provides a very efficient method to implement the constant-factor multiplication 1/1024.

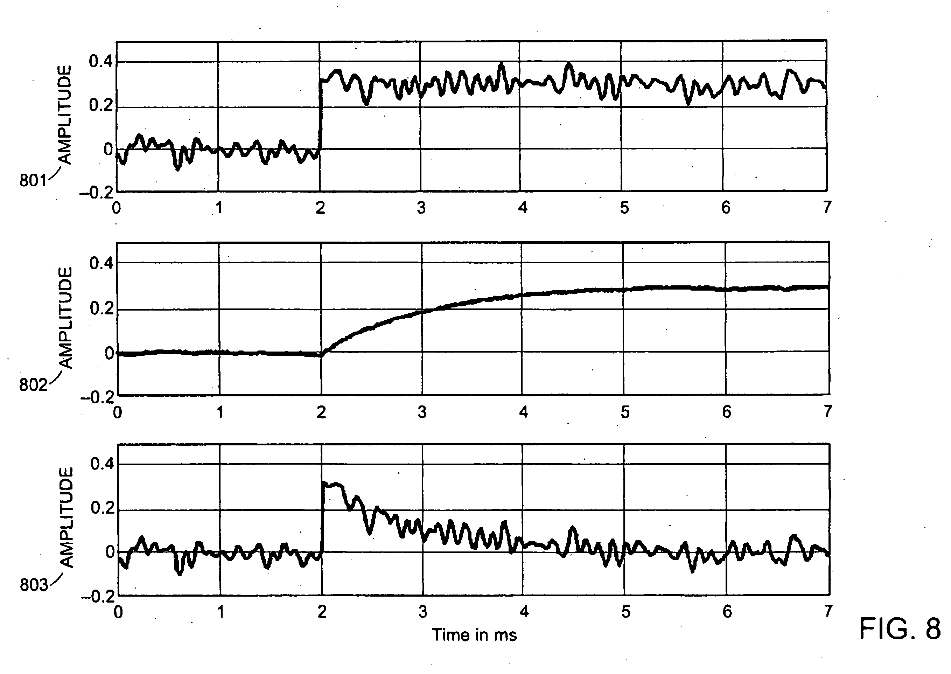

Signal $w_0(n)$ is the sigma-delta version of signal $\dfrac{az_0(n)}{1024}$. Thus, the number of bits has been reduced from 19 in signal $az_0(n)$ to 9 in signal $w_0(n)$. However, following the principles of multibit sigma-delta modulation, although there is a difference of 10 bits both signals contain almost the same information. Information contained in the 10 bit difference is preserved in the temporal fine structure of $w_0(n)$. Additionally, in this example, since both signals $z_0(n)$ and $w_0(n)$ are composed of 9 bits, the 2 DACs of Fig. 6 can be replaced by a single DAC 704, controlled by the sum 705 of signals $z_0(n)$ and $w_0(n)$. Fig. 8 depicts typical waveforms of the system in Fig. 7. The first trace 801 shows an input signal x(n) with a step-like transition after 2ms. The second trace 802 depicts the resulting 9-bit signal w(n), which shows the typical low-pass character. With a cut off frequency of about 150Hz, the time is about $\tau = \dfrac{1}{2\pi 150}s \approx 1ms$. As stated above, information is contained in the temporal fine structure of the signal. The third trace 803 shows the difference signal x(n)-w(n), which represents the high-pass filtered version of x(n).

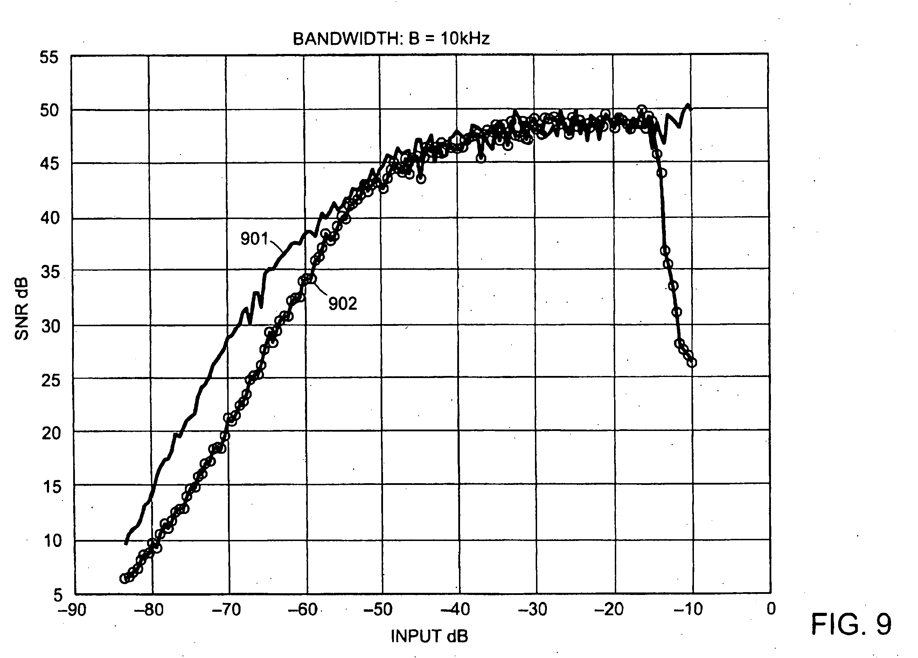

In Fig. 9, the SNR obtained with the system depicted in Fig. 7, using an ideal high-pass filter, is compared with the SNR obtained with the system depicted in Fig. 8, which uses a high-pass filter with numeric multibit sigma-delta modulator (employing 9-bit quantizers of mid-tread type), as waveforms 901 and 902, respectively. The same input signal as specified in Figs. 4 and 5, with N = 20000, is used. For both systems, the noise power in the signal band is derived from the difference between the system output signal and a reference signal. The reference signal is the high-pass filtered version of x(n), assuming the ideal transfer function (3). The additional noise introduced by the numeric multibit sigma-delta modulator results in a loss of SNR at low input power levels. The input dynamic range is reduced by approximately 6dB. The decrease of SNR at high input levels is due to a clipping effect and appears, if the sum $w_0(n)+z_0(n)$ exceeds the range [-255, 255]. The two SNR-curves 901, 902 are obtained assuming DAC's with $\Delta= 1\%$.

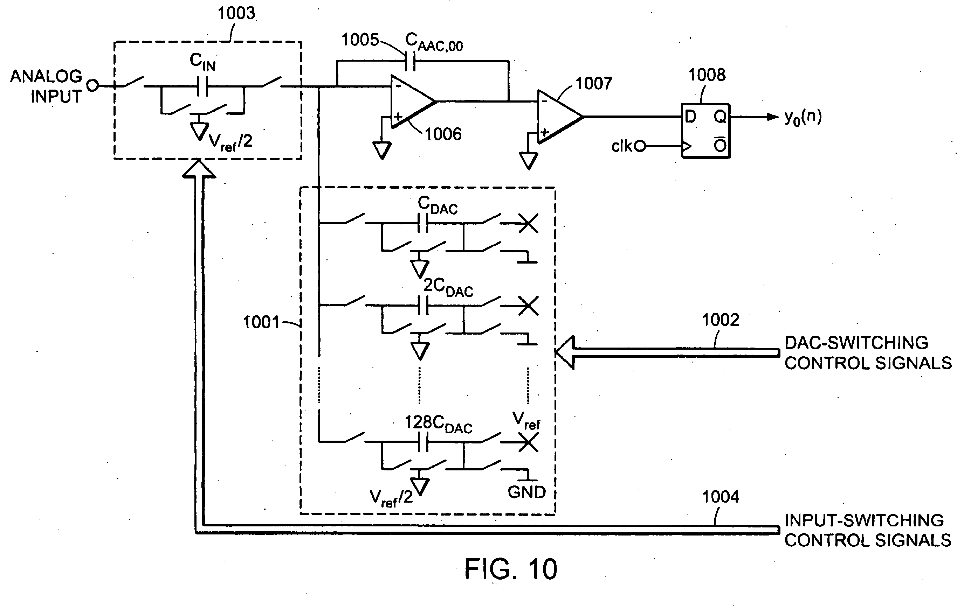

For the analog stages of the adaptive $\Sigma$-$\Delta$ modulator in Fig.7, standard Switched-Capacitor (SC-) technology may be used, as shown in Fig. 10, in accordance with one embodiment of the system. The 9-bit DAC 1001 is composed of an array of 8 binary weighted capacitors $C_{DAC}$, $2C_{DAC}$, $4C_{DAC}$, $8C_{DAC}$, $16C_{DAC}$, $32C_{DAC}$, $64C_{DAC}$, and $128C_{DAC}$. The analog input signal is processed by the input sampling stage 1003. Charge- and discharge operations of the arrays 1001 and 1003 are digitally controlled by DAC-Switching control signals 1002 and Input-Switching control signals 1004, which are generated in the digital part of the modulator. Together with the operational amplifier 1006 and the accumulation capacitor 1005, a typical subtract-and-accumulated operation can be described as follows. Each $\Sigma$-$\Delta$ clock period is subdivided into two sections of roughly equal length, the "sampling-section" and the "accumulation-section". During the "sampling-section", all capacitors in 1001 and 1003 are disconnected from the operational amplifier. The switches at the capacitors are set such that a charge $Q_{in}(n)$ proportional to the input signal x(n) is stored to 1003, and a charge $Q_{DAC}(n)$ proportional to the (negative) overall feedback signal -[z(n)+w(n)] is stored to 1001 (cf. Fig.7). Note that in practical implementation, input signal x(n) and the overall feedback signal z(n)+w(n ) may be referred to a constant potential, such as $V_{ref}/2$. During the "accumulation-section", the ports of the capacitors in 1001 and 1003 are switched such that the capacitors are discharged and the sum of the charges $Q_{in}(n)+Q_{DAC}(n)$ is forced to flow into the accumulation capacitor 1005. Thus, the charge in capacitor 1005 is changed by $Q_{in}(n)+Q_{DAC}(n)$. The sign of the new potential at the output of the operational amplifier referred to $V_{ref}/2$ is sensed by the comparator 1007, and clocked into flip-flop 1008 at the end of the "accumulation-section". Note that for proper operation both, chargeaccumulation and the sign-sensing have to be finished within the "accumulation-section", and therefore the response time of the comparator has to be shorter than 50% of a $\Sigma$-$\Delta$ clock period.

The adaptive $\Sigma$-$\Delta$ modulator imposes harsh requirements on the comparator 1007. The enhanced input dynamic range causes an equally enhanced dynamic range of the signal at the output of amplifier 1006, which applies at the comparator input. For example, consider a comparator input signal range of a non-adaptive modulator of +/-1V. The corresponding range for an adaptive modulator with a 9-bit DAC is +/-1V for the largest value of c(n), and +/-3.9mV for the smallest value of c(n). However, to achieve the desired and theoretically predicted SNR for the +/-1V-range and +/-3.9mV range, the switching behavior of the comparator has to be equal for both cases. Unfortunately, comparators tend to become slower as the input signal differences get smaller, and signals in the +/-3.9mV range are adversely affected. Thus, it has to be ensured that the comparator is sufficiently fast to track very small input signals.

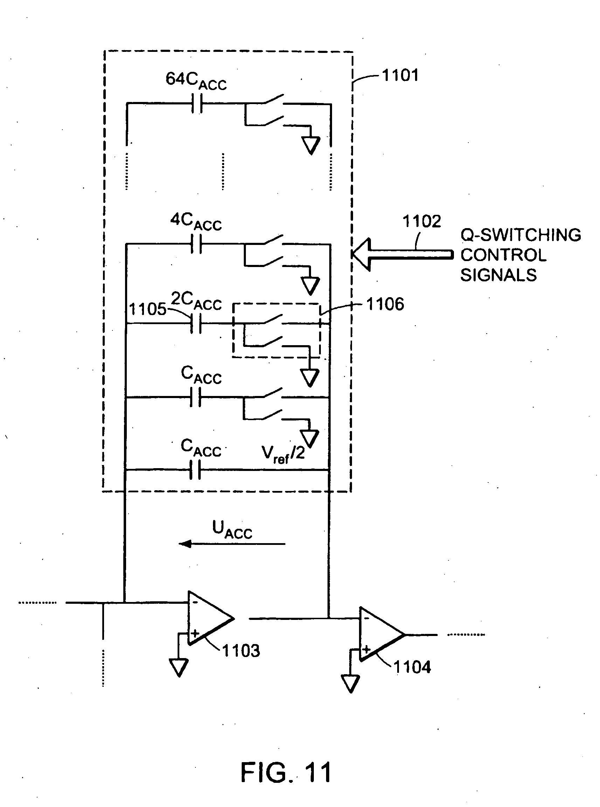

In accordance with one embodiment of the invention, one way to reduce the dynamic range of the comparator input signal is explained with the help of Fig.11. Here, the accumulation capacitor 1005 of Fig. 10 is replaced by an SC-array 1101 of capacitors $C_{ACC}$, $C_{ACC}$, $2C_{ACC}$, $4C_{ACC}$, $8C_{ACC}$, $16C_{ACC}$, $32C_{ACC}$, $64C_{ACC}$, and $128C_{ACC}$. The size of the feedback capacitor is adapted to the instantaneous input signal power. An overall feedback capacitance $C_{ACC,TOT}(n)$ is realized by switching a particular number of single capacitors in parallel. If the power of the input signal is small, the mean charge across the accumulation capacitor will also be comparatively small. Thus, a smaller overall feedback capacitance $C_{ACC,TOT}(n)$ can be selected, resulting in a larger voltage across the capacitor. On the other hand, an input signal with high power requires a large overall feedback capacitance $C_{ACC,TOT}(n)$ to keep the accumulation signal within specified ranges. The adaptation is carried out in the "sampling-section" of a $\Sigma$-$\Delta$ clock period, i.e., the preparation of charges $Q_{in}(n)$ in 1003 and $Q_{DAC}(n)$ in 1001 is not affected, since 1003 and 1001 are not connected to the operational amplifier. Two cases can be distinguished, (1) an uncharged capacitor is added to the configuration $C_{ACC,TOT}(n)$ of the previous clock period, and (2) a capacitor is removed from the instantaneous configuration $C_{ACC,TOT}(n)$. The two cases are explained with the help of capacitor 1105 and the associated switcharray 1106 for clock period number (n+1). One port of each capacitor in the array 1101 is permanently connected to the inverting input of amplifier 1103.

Case (1): An uncharged capacitor 1105 can be added to the active array $C_{ACC,TOT}(n)$ by configuring 1106 such that the second port is connected to the amplifier output during the whole period number (n+1). This causes a redistribution of the charges and a thus a change in the voltage $U_{ACC}$, i.e., it changes from $\dfrac{Q_{ACC}(n)}{C_{ACC,TOT}(n)}$ to $\dfrac{Q_{ACC}(n)}{C_{ACC,TOT}(n) + 2C_{ACC}}$,

where $Q_{ACC}(n)$ is the charge in array 1105 at the end of the clock period number n and in the "sampling-section" of period number (n+1). The magnitude of $U_{ACC}$ is decreased in this case, since the overall capacitance $C_{ACC,TOT}(n+1)$ = $C_{ACC,TOT}(n)+2C_{ACC}$ has been increased at a constant charge.

Case (2): Removing capacitor 1105 from the active array $C_{ACC,TOT}$ is achieved by switching 1106 such that the second port is connected to the reference voltage $V_{ref}/2$ during the whole period number (n+1). Since this potential is equal the virtual potential of the inverting input of amplifier 1103, the amplifier forces the output to change its potential from $\dfrac{Q_{ACC}(n)}{C_{ACC,TOT}(n)}$ to $\dfrac{Q_{ACC}(n)}{C_{ACC,TOT}(n) - 2C_{ACC}}$. As above, $Q_{ACC}(n)$ is the charge in array 1105 at the end of the clock period number n and in the "sampling-section" of period number (n+1). The magnitude of $U_{ACC}$ is increased in this case, since the overall capacitance $C_{ACC,TOT}(n+1)=C_{ACC,TOT}(n) - 2C_{ACC}$ has been decreased at a constant charge.

In various embodiments of the invention, the adaptation of $C_{ACC,TOT}(n)$ is achieved based, at least in part, on digital signal $c_0(n)$. An example of an adaptation scheme is summarized in Table 2 for an 8-bit signal $c_0(n)$. Here, the first non-zero bit within $c_0(n)$ is directly used to define $C_{ACC,TOT}(n)$. Note that the exact value of $C_{ACC,TOT}(n)$ is not critically important. In various embodiments of the invention, the adaptation algorithm ensures that (1) on average, the magnitude of voltage $U_{ACC}$ is maximized, but the instantaneous value of $U_{ACC}$ does not exceed specified limits at no time instant, and (2) the switching between different configurations of 1101 is performed without any significant loss of charge, and preferably no loss of charge. Loss of charge in 1101 results in accumulation errors and thus reduces the system performance.

Table 2: Example of an adaptation scheme for Q-switching

| Bit pattern $c_0(n)$ | Overall capacitance $C_{ACC,TOT}(n)$ |
| --- | --- |
| [1 x x x x x x x] | $128C_{ACC}$ |
| [0 1 x x x x x x] | $64C_{ACC}$ |
| [0 0 1 x x x x x] | $32C_{ACC}$ |
| [0 0 0 1 x x x x] | $16C_{ACC}$ |
| [0 0 0 0 1 x x x] | $8C_{ACC}$ |
| [0 0 0 0 0 1 x x] | $4C_{ACC}$ |
| [0 0 0 0 0 0 1 x] | $2C_{ACC}$ |
| [0 0 0 0 0 0 0 1] | $C_{ACC}$ |

The above-described manner for reducing the dynamic range of the comparator input signal may be applicable to a wide variety of adaptive and non-adaptive $\Sigma$-$\Delta$ modulators, and is not limited to an adaptive $\Sigma$-$\Delta$ modulator in which the adaptation stage tends to keep the instantaneous magnitude of the analog feedback signal $z(n)$ within the first range [-a, +a] and greater than the analog input signal's $x(n)$ instantaneous magnitude.

Alternative embodiments of the invention may be implemented as a computer program product for use with a computer system. Such implementation may include a series of computer instructions fixed either on a tangible medium, such as a computer readable media (e.g., a diskette, CD-ROM, ROM, or fixed disk), or fixed in a computer data signal embodied in a carrier wave that is transmittable to a computer system via a modem or other interface device, such as a communications adapter connected to a network over a medium. The medium may be either a tangible medium (e.g., optical or analog communications lines) or a medium implemented with wireless techniques (e.g., microwave, infrared or other transmission techniques). The series of computer instructions embodies all or part of the functionality previously described herein with respect to the system. Those skilled in the art should appreciate that such computer instructions can be written in a number of programming languages for use with many computer architectures or operating systems. Furthermore, such instructions may be stored in any memory device, such as semiconductor, magnetic, optical or other memory devices, and may be transmitted using any communications technology, such as optical, infrared, microwave, or other transmission technologies. It is expected that such a computer program product may be distributed as a removable medium with accompanying printed or electronic documentation (e.g., shrink wrapped software), preloaded with a computer system (e.g., on system ROM or fixed disk), or distributed from a server or electronic bulletin board over the network (e.g., the Internet or World Wide Web).

## Claims

1. An adaptive sigma delta modulator (203) comprising: an input stage (208) that produces a difference signal representing the difference between an analog input signal ($x(n)$) and an analog feedback signal ($z(n)$) the amplitude of the analog input signal ($x(n)$ being within a first range [-a, +a]; an accumulator stage (209) that outputs a comparator input signal that is a function of an accumulation of the difference signal, wherein the accumulator stage (209) includes an accumulation capacitor (1105) ; a quantization stage (202) having a comparator (1007) that receives the comparator input signal from the accumulator stage (209) and produces a quantized digital signal ($y_0(n)$) representing a quantization of the comparator input signal; an adaptation stage (205) that, based on the quantized digital signal ($y_0(n)$), produces a digital output signal ($z_0(n)$); and a digital-to-analog converter stage (204) that converts the digital output signal ($z_0(n)$) to the analog feedback signal ($z(n)$); the adaptive sigma delta modulator (203) **characterized in that** the accumulation capacitor (1105) has a capacitance that is variably controlled to transform the accumulation of the difference signal into the comparator input signal so as to reduce the dynamic range of the comparator input signal.

2. An adaptive sigma delta modulator according to claim 1 wherein the adaptation stage (205) includes a multiplier stage that multiplies the quantized digital signal ($y_0(n)$) by a step size $c_0(n)$, the step size ($c_0(n)$) determined so as to drive the instantaneous magnitude of the analog feedback signal ($z(n)$) within the first range [-a, +a] and greater than the analog input signal's ($x(n)$) instantaneous magnitude.

3. An adaptive sigma delta modulator according to claim 1 wherein the accumulated signal is based, at least in part, on the voltage across the accumulation capacitor (1005).

4. An adaptive sigma delta modulator according to claim 1 wherein the capacitance across the accumulation capacitor (1005) is variably controlled such that average magnitude of voltage across the accumulation capacitor (1005) is increased while ensuring instantaneous magnitude of voltage across the accumulation capacitor (1005) does not exceed a predetermined value.

5. An adaptive sigma delta modulator according to claim 1 wherein the accumulation capacitor (1005) is coupled between an input and an output of an operational amplifier (1006).

6. An adaptive sigma delta modulator according to claim 1 wherein the adaptation stage (205) includes a multiplier stage that multiplies the quantized digital signal ($y_0(n)$) by a step size ($c_0(n)$), and wherein the capacitance across the accumulation capacitor (1005) is variably controlled based, at least in part, on the step size ($c_0(n)$).

7. An adaptive sigma delta modulator according to claim 1 wherein the accumulation capacitor (1005) includes an array of capacitors (1101), each capacitor in the array (1101) capable of being switched so as to vary the capacitance across the accumulation capacitor (1005).

8. An adaptive sigma delta modulator according to claim 1 wherein the digital-to-analog converter (204) includes an array of weighted capacitors, the array of weighted capacitors capable of acquiring a charge $Q_{DAC}(n)$) negatively proportional to the digital output signal ($z_0(n)$).

9. An adaptive sigma delta modulator according to claim 1 wherein the input sampling stage (1003) includes an input sampling capacitor, the input sampling capacitor capable of acquiring a charge ($Q_{in}(n)$) proportional to the analog input signal ($x(n)$).

10. A method of adapting sigma delta modulation, the method comprising: producing a difference signal representing the difference between an analog input signal ($x(n)$) and an adaptive feedback signal ($z(n)$), the amplitude of the analog input ($x(n)$) being within a first range [-a, +a]; producing a comparator input signal that is a function of an accumulation in an accumulation capacitor (1105) of the difference signal ; receiving the comparator input signal at a comparator (1007) and producing a quantized digital signal ($y_0(n)$) representing a quantization of the comparator input signal; producing a digital output signal ($z_0(n)$) based on the quantized digital signal ($y_0(n)$); and performing a digital-to-analog conversion on the digital output signal ($z_0(n)$) to produce the adaptive feedback signal ($z(n)$); the method **characterized in that** producing the comparator input signal includes variably controlling capacitance across the accumulation capacitor (1005) to transform the accumulation of the difference signal into the comparator input signal so as to reduce the dynamic range of the comparator input signal.

11. A method according to claim 10 wherein producing a digital output signal ($z_0(n)$) includes multiplying the quantized digital signal ($y_0(n)$) by a step size ($c_0(n)$), the step size ($c_0(n)$) determined so as to drive the instantaneous magnitude of the analog feedback signal ($z(n)$) within the first range [-a, +a] and greater than the analog input signal's ($x(n)$) instantaneous magnitude.

12. A method according to claim 10 wherein producing the accumulated signal includes storing charge across the accumulation capacitor, the charge representing the accumulation of the difference signal.

13. A method according to claim 10 wherein variably controlling capacitance across the accumulation capacitor includes variably controlling capacitance across the accumulation capacitor so as to increase the average voltage across the accumulation capacitor while ensuring instantaneous voltage across the accumulation capacitor does not exceed a predetermined value.

14. A method according to claim 10 wherein producing the digital output signal ($z_0(n)$) includes multiplying the quantized digital signal ($y_0(n)$) by a step size ($c_0(n)$), and wherein variably controlling capacitance across the accumulation capacitor includes varying the capacitance across the accumulation capacitor based, at least in part, on the step size ($c_0(n)$).

15. A method according to claim 10 wherein the accumulation capacitor is coupled between an input and an output of an operational amplifier.

16. A method according to claim 10 wherein the accumulation capacitor includes an array of capacitors, and wherein variably controlling capacitance across the accumulation capacitor includes switching at least one capacitor in the array so as to vary the capacitance across the accumulation capacitor.

17. A method according to claim 16 wherein switching at least one capacitor in the array includes disconnecting at least one capacitor in the array so as to decrease the capacitance across the accumulation capacitor.

18. A method according to claim 16 wherein switching at least one capacitor in the array includes activating at least one capacitor in the array so as to increase the capacitance across the accumulation capacitor.

19. A method according to claim 10 wherein variably controlling capacitance across the accumulation capacitor includes losing substantially no charge across the accumulation capacitor.

20. A method according to claim 10 wherein performing the digital-to-analog conversion on the digital output signal $z_0(n)$) to produce the adaptive feedback signal ($z(n)$) includes acquiring a charge ($Q_{DAC}(n)$) on an array of weighted capacitors, the charge ($Q_{DAC}(n)$) negatively proportional to the digital output signal ($Z_0(n)$).

21. A method according to claim 10 wherein producing the difference signal includes acquiring a charge ($Q_{in}(n)$) on an input sampling capacitor, the charge ($Q_{in}(n)$) proportional to the analog input signal ($x(n)$).

**Patentansprüche**

1. Adaptiver Sigma-Delta-Modulator (203), welcher aufweist: eine Eingangsstufe (208), welche ein Differenzsignal herstellt, welches die Differenz zwischen einem analogen Eingangssignal ($x(n)$) und einem analogen Rückkopplungssignal ($z(n)$) darstellt, wobei die Amplitude des analogen Eingangssignals ($x(n)$) innerhalb eines ersten Bereichs [-a, +a] liegt; eine Akkumulatorstufe (209), welche ein Komparator- bzw. Vergleichseingangssignal ausgibt, welches eine Funktion einer Akkumulation des Differenzsignals ist, wobei die Akkumulatorstufe (209) einen Akkumulationskondensator (1105) beinhaltet; eine Quantisierungsstufe (202), welche einen Komparator (1007) besitzt, welcher das Komparator-Eingangssignal von der Akkumulatorstufe (209) empfängt und ein quantisiertes Digitalsignal ($y_0(n)$) herstellt, welches eine Quantisierung des Komparator-Eingangssignals darstellt; eine Adaptionsstufe (205), welche basierend auf dem quantisierten Digitalsignal ($y_0(n)$) ein digitales Ausgangssignal ($z_0(n)$) liefert; und eine Digital/Analog-Wandlerstufe (204), welche das digitale Ausgangssignal ($z_0(n)$) in das analoge Rückkopplungssignal ($z(n)$) wandelt; wobei der adaptive Sigma-Delta-Modulator (203) **dadurch gekennzeichnet ist, dass** der Akkumulationskondensator (1105) eine Kapazität besitzt, welche variabel gesteuert ist, um die Akkumulation des Differenzsignals in das Komparator-Eingangssignal umzuformen, um den dynamischen Bereich des Komparator-Eingangssignals zu reduzieren.

2. Adaptiver Sigma-Delta-Modulator nach Anspruch 1, wobei die Adaptionsstufe (205) eine Vervielfacherstufe beinhaltet, welche das quantisierte Digitalsignal ($y_0(n)$) mit einer Schrittweite ($c_0(n)$) multipliziert, wobei die Schrittweite ($c_0(n)$) so festgelegt ist, um die momentane Größe des analogen Rückkopplungssignals ($z(n)$) innerhalb des ersten Bereiches [-a, +a] und größer als die momentane Größe des analogen Eingangssignals ($x(n)$) zu treiben.

3. Adaptiver Sigma-Delta-Modulator nach Anspruch 1, wobei das akkumulierte Signal wenigstens zum Teil auf der Spannung über den Akkumulationskondensator (1005) hinweg basiert.

4. Adaptiver Sigma-Delta-Modulator nach Anspruch 1, wobei die Kapazität über den Akkumulationskondensator (1005) hinweg variabel so gesteuert wird, dass die durchschnittliche Größe der Spannung über den Akkumulationskondensator (1005) hinweg erhöht wird, während sichergestellt wird, dass die momentane Größe der Spannung über den Akkumulationskondensator (1005) hinweg nicht einen vorher festgelegten Wert überschreitet.

5. Adaptiver Sigma-Delta-Modulator nach Anspruch 1, wobei der Akkumulationskondensator (1005) zwischen einem Eingang und einem Ausgang eines Operationsverstärkers (1006) gekoppelt ist.

6. Adaptiver Sigma-Delta-Modulator nach Anspruch 1, wobei die Adaptionsstufe (205) eine Vervielfacherstufe beinhaltet, welche das quantisierte Digitalsignal ($y_0(n)$) mit einer Schrittweite ($c_0(n)$) multipliziert, und wobei die Kapazität über den Akkumulationskondensator (1005) basierend (wenigstens zum Teil) auf der Schrittweite ($c_0(n)$) variabel gesteuert wird.

7. Adaptiver Sigma-Delta-Modulator nach Anspruch 1, wobei der Akkumulationskondensator (1005) ein Feld von Kondensatoren (1101) beinhaltet, wobei jeder Kondensator in dem Feld (1101) in der Lage ist, so geschaltet zu werden, um die Kapazität über den Akkumulationskondensator (1005) hinweg zu variieren.

8. Adaptiver Sigma-Delta-Modulator nach Anspruch 1, wobei der Digital/AnalogWandler (204) ein Feld von gewichteten Kondensatoren beinhaltet, wobei das Feld der gewichteten Kondensatoren in der Lage ist, eine Ladung ($Q_{DAC}(n)$) negativ proportional zu dem digitalen Ausgangssignal ($z_0(n)$) zu erlangen.

9. Adaptiver Sigma-Delta-Modulator nach Anspruch 1, wobei die Eingangs-Abtaststufe (1003) einen Eingangsabtastkondensator beinhaltet, wobei der Eingangsabtastkondensator in der Lage ist, eine Ladung ($Q_{in}(n)$) proportional zu dem analogen Eingangssignal ($x(n)$) zu erlangen.

10. Verfahren für das Adaptieren einer Sigma-Delta-Modulation, wobei das Verfahren aufweist: Herstellen eines Differenzsignals, welches die Differenz zwischen einem analogen Eingangssignal ($x(n)$) und einem adaptiven Rückkopplungssignal ($z(n)$) aufweist, wobei die Amplitude des analogen Eingangssignals ($x(n)$) innerhalb eines ersten Bereiches [-a, +a] liegt; Herstellen eines Komparator-Eingangssignals, welches eine Funktion einer Akkumulierung in einem Akkumulationskondensator (1105) des Differenzsignals ist; Empfangen des Komparator-Eingangssignals an einem Komparator (1007) und Herstellen eines quantisierten digitalen Signals ($y_0(n)$), welches eine Quantisierung des Komparator-Eingangssignals darstellt; Herstellen eines digitalen Ausgangssignals ($z_0(n)$), basierend auf dem quantisierten Digitalsignal ($y_0(n)$); und Ausführen einer Digital/Analog-Wandlung an dem digitalen Ausgangssignal ($z_0(n)$), um das adaptive Rückkopplungssignal ($z_0(n)$) herzustellen; wobei das Verfahren **dadurch gekennzeichnet ist, dass** das Herstellen des Komparator-Eingangssignals das variable Steuern der Kapazität über den Akkumlationskondensator (1005) hinweg beinhaltet, um die Akkumulation des Differenzsignals in das Komparator-Eingangssignal so überzuführen, um den dynamischen Bereich des Komparator-Eingangssignals zu reduzieren.

11. Verfahren nach Anspruch 10, wobei das Herstellen eines digitalen Ausgangssignals ($z_0(n)$) das Multiplizieren des quantisierten Digitalsignals ($y_0(n)$) mit einer Schrittweite ($c_0(n)$) beinhaltet, wobei die Schrittweite ($c_0(n)$) so festgelegt ist, um die momentane Größe des analogen Rückkopplungssignals ($z(n)$) innerhalb des ersten Bereiches [-a, +a] und größer als die momentane Größe des analogen Eingangssignals ($x(n)$) zu treiben.

12. Verfahren nach Anspruch 10, wobei das Herstellen des akkumulierten Signals das Speichern der Ladung über den Akkumulationskondensator hinweg beinhaltet, wobei die Ladung die Akkumulation bzw. Addierung des Differenzsignals darstellt.

13. Verfahren nach Anspruch 10, wobei das variable Steuern der Kapazität über den Akkumulationskondensator hinweg das variable Steuern der Kapazität über den Akkumulationskondensator so beinhaltet, um die durchschnittliche Spannung über den Akkumulationskondensator hinweg zu erhöhen, während sichergestellt wird, dass die momentane Spannung über den Akkumulationskondensator hinweg nicht einen vorher festgelegten Wert übersteigt.

14. Verfahren nach Anspruch 10, wobei das Herstellen des digitalen Ausgangssignals ($z_0(n)$) das Multiplizieren des quantisierten Digitalsignals ($y_0(n)$) und einer Schrittweite ($c_0(n)$) beinhaltet und wobei das variable Steuern der Kapazität über den Akkumulationskondensator hinweg das Variieren der Kapazität über den Akkumulationskondensator hinweg basierend auf, wenigstens zum Teil, auf der Schrittweite ($c_0(n)$) beinhaltet.

15. Verfahren nach Anspruch 10, wobei der Akkumulationskondensator zwischen einem Eingang und einem Ausgang eines Operationsverstärkers gekoppelt ist.

**16.** Verfahren nach Anspruch 10, wobei der Akkumulationskondensator ein Feld von Kondensatoren beinhaltet und wobei das variable Steuern der Kapazität über den Akkumlationskondensator hinweg das Schalten wenigstens eines Kondensators in dem Array so beinhaltet, dass die Kapazität über den Akkumulationskondensator hinweg variiert wird.

**17.** Verfahren nach Anspruch 16, wobei das Schalten wenigstens eines Kondensators in dem Feld das Trennen wenigstens eines Kondensators in dem Feld so beinhaltet, um die Kapazität über den Akkumulationskondensator hinweg zu erniedrigen.

**18.** Verfahren nach Anspruch 16, wobei das Schalten wenigstens eines Kondensators in dem Feld das Aktivieren wenigstens eines Kondensators in dem Feld so beinhaltet, um die Kapazität über den Akkumlationskondensator hinweg zu erhöhen.

**19.** Verfahren nach Anspruch 10, wobei das variable Steuern der Kapazität über den Akkumulationskondensator hinweg das Verlieren von hauptsächlich keiner Ladung über den Akkumulationskondensator hinweg beinhaltet.

**20.** Verfahren nach Anspruch 10, wobei das Durchführen der Digital/Analog-Wandlung an dem digitalen Ausgangssignal ($z_0(n)$), um das adaptive Rückkopplungssignal ($z(n)$) herzustellen, das Erwerben einer Ladung ($Q_{DAC}(n)$) auf einem Feld von gewichteten Kondensatoren beinhaltet, wobei die Ladung ($Q_{DAC}(n)$) negativ proportional zu dem digitalen Ausgangssignal ($z_0(n)$) ist.

**21.** Verfahren nach Anspruch 10, wobei das Herstellen des Differenzsignals das Erwerben einer Ladung ($Q_{in}(n)$) an einem Eingangsabtastkondensator beinhaltet, wobei die Ladung ($Q_{in}(n)$) proportional zu dem analogen Eingangssignal ($x(n)$) ist.

**Revendications**

**1.** Modulateur sigma delta adaptatif (203) comprenant : un étage d'entrée (208) qui produit un signal de différence représentant la différence entre un signal d'entrée analogique ($x(n)$) et un signal de rétroaction analogique ($z(n)$), l'amplitude du signal d'entrée analogique ($x(n)$) étant dans une première plage [-a, +a] ; un étage d'accumulateur (209) qui délivre un signal d'entrée de comparateur qui est fonction d'une accumulation du signal de différence, dans lequel l'étage d'accumulateur (209) comprend un condensateur d'accumulation (1105) ; un étage de quantification (202) comportant un comparateur (1007) qui reçoit le signal d'entrée de comparateur de l'étage d'accumulateur (209) et produit un signal numérique quantifié ($y_0(n)$) représentant une quantification du signal d'entrée de comparateur ; un étage d'adaptation (205) qui, sur la base du signal numérique quantifié ($y_0(n)$), produit un signal de sortie numérique ($z_0(n)$) ; et un étage de convertisseur numérique-analogique (204) qui convertit le signal de sortie numérique ($z_0(n)$) en le signal de rétroaction analogique ($z(n)$) ; le modulateur sigma delta adaptatif (203) étant **caractérisé en ce que** le condensateur d'accumulation (1105) comporte une capacitance qui est commandée de manière variable pour transformer l'accumulation du signal de différence en le signal d'entrée de comparateur de manière à réduire la plage dynamique du signal d'entrée de comparateur.

**2.** Modulateur sigma delta adaptatif selon la revendication 1, dans lequel l'étage d'adaptation (205) comprend un étage de multiplicateur qui multiplie le signal numérique quantifié ($y_0(n)$) par une taille de pas co(n), la taille de pas co(n) étant déterminée de manière à commander l'amplitude instantanée du signal de rétroaction analogique ($z(n)$) dans la première plage [-a, +a] et pour qu'elle soit supérieure à l'amplitude instantanée du signal d'entrée analogique ($x(n)$).

**3.** Modulateur sigma delta adaptatif selon la revendication 1, dans lequel le signal accumulé est basé, au moins en partie, sur la tension aux bornes du condensateur d'accumulation (1005).

**4.** Modulateur sigma delta adaptatif selon la revendication 1, dans lequel la capacitance aux bornes du condensateur d'accumulation (1005) est commandée de manière variable de sorte que l'amplitude moyenne de la tension aux bornes du condensateur d'accumulation (1005) soit augmentée tout en garantissant que l'amplitude instantanée de la tension aux bornes du condensateur d'accumulation (1005) ne dépasse pas une valeur prédéterminée.

**5.** Modulateur sigma delta adaptatif selon la revendication 1, dans lequel le condensateur d'accumulation (1005) est couplé entre une entrée et une sortie d'un amplificateur opérationnel (1006).

6. Modulateur sigma delta adaptatif selon la revendication 1, dans lequel l'étage d'adaptation (205) comprend un étage de multiplicateur qui multiplie le signal numérique quantifié ($y_0(n)$) par une taille de pas co(n), et dans lequel la capacitance aux bornes du condensateur d'accumulation (1005) est commandée de manière variable sur la base, au moins en partie, de la taille de pas co(n).

7. Modulateur sigma delta adaptatif selon la revendication 1, dans lequel le condensateur d'accumulation (1005) comprend un ensemble de condensateurs (1101), chaque condensateur dans l'ensemble (1101) étant capable d'être commuté de manière à faire varier la capacitance aux bornes du condensateur d'accumulation (1005).

8. Modulateur sigma delta adaptatif selon la revendication 1, dans lequel le convertisseur numérique-analogique (204) comprend un ensemble de condensateurs pondérés, l'ensemble de condensateurs pondérés étant capable d'acquérir une charge ($Q_{DAC}(n)$) négativement proportionnelle au signal de sortie numérique ($z_0(n)$).

9. Modulateur sigma delta adaptatif selon la revendication 1, dans lequel l'étage d'échantillonnage d'entrée (1003) comprend un condensateur d'échantillonnage d'entrée, le condensateur d'échantillonnage d'entrée étant capable d'acquérir une charge ($Q_{in}(n)$) proportionnelle au signal d'entrée analogique ($x(n)$).

10. Procédé d'adaptation de modulation sigma delta, le procédé consistant à : produire un signal de différence représentant la différence entre un signal d'entrée analogique ($x(n)$) et un signal de rétroaction adaptatif ($z(n)$), l'amplitude du signal d'entrée analogique ($x(n)$) étant dans une première plage [-a, +a] ; produire un signal d'entrée de comparateur qui est fonction d'une accumulation dans un condensateur d'accumulation (1105) du signal de différence ; recevoir le signal d'entrée de comparateur au niveau d'un comparateur (1007) et produire un signal numérique quantifié ($y_0(n)$) représentant une quantification du signal d'entrée de comparateur ; produire un signal de sortie numérique ($z_0(n)$) sur la base du signal numérique quantifié ($y_0(n)$) ; et appliquer une conversion numérique-analogique au signal de sortie numérique ($z_0(n)$) pour produire le signal de rétroaction adaptatif ($z(n)$) ; le procédé étant **caractérisé en ce que** la production du signal d'entrée de comparateur comprend la commande de manière variable de la capacitance aux bornes du condensateur d'accumulation (1005) pour transformer l'accumulation du signal de différence en le signal d'entrée de comparateur de manière à réduire la plage dynamique du signal d'entrée de comparateur.

11. Procédé selon la revendication 10, dans lequel la production d'un signal de sortie numérique ($z_0(n)$) comprend la multiplication du signal numérique quantifié ($y_0(n)$) par une taille de pas co(n), la taille de pas co(n) étant déterminée de manière à commander l'amplitude instantanée du signal de rétroaction analogique ($z(n)$) dans la première plage [-a, +a] et pour qu'elle soit supérieure à l'amplitude instantanée du signal d'entrée analogique ($x(n)$).

12. Procédé selon la revendication 10, dans lequel la production du signal accumulé comprend le stockage d'une charge aux bornes du condensateur d'accumulation, la charge représentant l'accumulation du signal de différence.

13. Procédé selon la revendication 10, dans lequel la commande de manière variable de la capacitance aux bornes du condensateur d'accumulation comprend la commande de manière variable de la capacitance aux bornes du condensateur d'accumulation de manière à augmenter la tension moyenne aux bornes du condensateur d'accumulation tout en garantissant que la tension instantanée aux bornes du condensateur d'accumulation ne dépasse pas une valeur prédéterminée.

14. Procédé selon la revendication 10, dans lequel la production du signal de sortie numérique ($z_0(n)$) comprend la multiplication du signal numérique quantifié ($y_0(n)$) par une taille de pas co(n), et dans lequel la commande de manière variable de la capacitance aux bornes du condensateur d'accumulation consiste à faire varier la capacitance aux bornes du condensateur d'accumulation sur la base, au moins en partie, de la taille de pas co(n).

15. Procédé selon la revendication 10, dans lequel le condensateur d'accumulation est couplé entre une entrée et une sortie d'un amplificateur opérationnel.

16. Procédé selon la revendication 10, dans lequel le condensateur d'accumulation comprend un ensemble de condensateurs, et dans lequel la commande de manière variable de la capacitance aux bornes du condensateur d'accumulation comprend la commutation d'au moins un condensateur dans l'ensemble de manière à faire varier la capacitance aux bornes du condensateur d'accumulation.

17. Procédé selon la revendication 16, dans lequel la commutation d'au moins un condensateur dans l'ensemble comprend la déconnexion d'au moins un condensateur dans l'ensemble de manière à diminuer la capacitance aux bornes du condensateur d'accumulation.

18. Procédé selon la revendication 16, dans lequel la commutation d'au moins un condensateur dans l'ensemble comprend l'activation d'au moins un condensateur dans l'ensemble de manière à augmenter la capacitance aux bornes du condensateur d'accumulation.

19. Procédé selon la revendication 10, dans lequel la commande de manière variable de la capacitance aux bornes du condensateur d'accumulation consiste à ne perdre sensiblement aucune charge aux bornes du condensateur d'accumulation.

20. Procédé selon la revendication 10, dans lequel l'application de la conversion numérique-analogique au signal de sortie numérique ($z_0(n)$) pour produire le signal de rétroaction adaptatif ($z(n)$) comprend l'acquisition d'une charge ($Q_{DAC}(n)$) sur un ensemble de condensateurs pondérés, la charge ($Q_{DAC}(n)$) étant négativement proportionnelle au signal de sortie numérique ($z_0(n)$).

21. Procédé selon la revendication 10, dans lequel la production du signal de différence comprend l'acquisition d'une charge ($Q_{in}(n)$) sur un condensateur d'échantillonnage d'entrée, la charge ($Q_{in}(n)$) étant proportionnelle au signal d'entrée analogique ($x(n)$).

**FIG. 1A**

PRIOR ART

**FIG. 1B**

PRIOR ART

FIG. 2

FIG. 3A

EP 1 855 384 B1

FIG. 3B

EP 1 855 384 B1

BANDWIDTH: B = 10kHz

FIG. 4

EP 1 855 384 B1

FIG. 5

FIG. 6

EP 1 855 384 B1

FIG. 7

FIG. 8

FIG. 9

BANDWIDTH: B = 10kHz

SNR dB

INPUT dB

901

902

FIG. 10

**FIG. 11**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 09496756 B
- US 6535153 B
- US 10357613 B

### Non-patent literature cited in the description

- Oversampling Delta-Sigma Data Converters. IEEE Press, 1992
- *Delta-Sigma Data Converters,* 1997
- **Zierhofer C. M.** Adaptive sigma-delta modulation with one-bit quantization. *IEEE trans. CAS II,* 05 May 2000, vol. 47
- **Chakravarthy, C. V.** An amplitude-controlled adaptive delta sigma modulator. *Radio & Electronic Engineer,* January 1979, vol. 49, 49-54
- **Jaggi, M. P.** Instantaneously Adaptive Delta Sigma Modulator. *Can. Elect. Eng. 1,* 1986, vol. 11 (1